# FASCICULE DE BREVET EUROPEEN

(11) **EP 3 555 921 B1**
(45) Date de publication et mention de la délivrance du brevet: **18.08.2021**
(21) Numéro de dépôt: 17794380.0
(22) Date de dépôt: 16.10.2017
(51) Int. Cl.: H01L 27/30, H01L 51/42, H01L 31/078, H01L 31/0725

(54) **DISPOSITIF PHOTOVOLTAÏQUE TANDEM COMPRENANT UNE SOUS-CELLULE À BASE DE PEROVSKITE ET UNE SOUS-CELLULE A BASE DE SILICIUM**
TANDEM-FOTOVOLTAIKZELLE MIT EINER SUBZELLE AUF BASIS VON PEROWSKIT UND EINER SUBZELLE AUF BASIS VON SILIZIUM
TANDEM PHOTOVOLTAIC DEVICE COMPRISING A SUB-CELL BASED ON PEROVSKITE AND A SUB-CELL BASED ON SILICON

(30) Priorité: 15.12.2016 FR 1662472
(43) Date de publication de la demande: 23.10.2019
(73) Titulaire: Commissariat à l'Énergie Atomique et aux Énergies Alternatives, 75015 Paris (FR)
(72) Inventeur: BERSON, Solenn, 73000 Chambery (FR); MANCEAU, Matthieu, 73000 Chambery (FR); MUNOZ, Maria-Delfina, 38380 Saint Christophe sur Guiers (FR)
(74) Mandataire: Cabinet Laurent & Charras
(86) Numéro de dépôt international: PCT/FR2017/052837
(87) Numéro de publication internationale: WO 2018/109289

(56) Documents cités:
- WO-A1-2016/012274
- FR-A1- 3 022 079
- NIESEN BJOERN ET AL: "High-efficiency perovskite/silicon heterojunction tandem solar cells", 2016 IEEE 43RD PHOTOVOLTAIC SPECIALISTS CONFERENCE (PVSC), IEEE, 5 juin 2016 (2016-06-05), pages 77-81, XP033007579, DOI: 10.1109/PVSC.2016.7749412

## Description

### DOMAINE DE L'INVENTION

La présente invention concerne un dispositif photovoltaïque tandem combinant une sous-cellule à base de pérovskite et une sous-cellule à hétérojonction de silicium.

Le domaine d'application de ce dispositif a trait aux cellules photovoltaïques permettant la conversion d'énergie solaire en énergie électrique.

### ETAT ANTERIEUR DE LA TECHNIQUE

Le développement d'alternatives aux énergies fossiles constitue un enjeu primordial, que ce soit d'un point de vue environnemental ou économique.

Les dispositifs photovoltaïques permettent de convertir l'énergie solaire en énergie électrique, ce qui les rend particulièrement attrayants. Cependant, ils présentent des rendements de conversion et une durée de vie limitant leurs champs d'application.

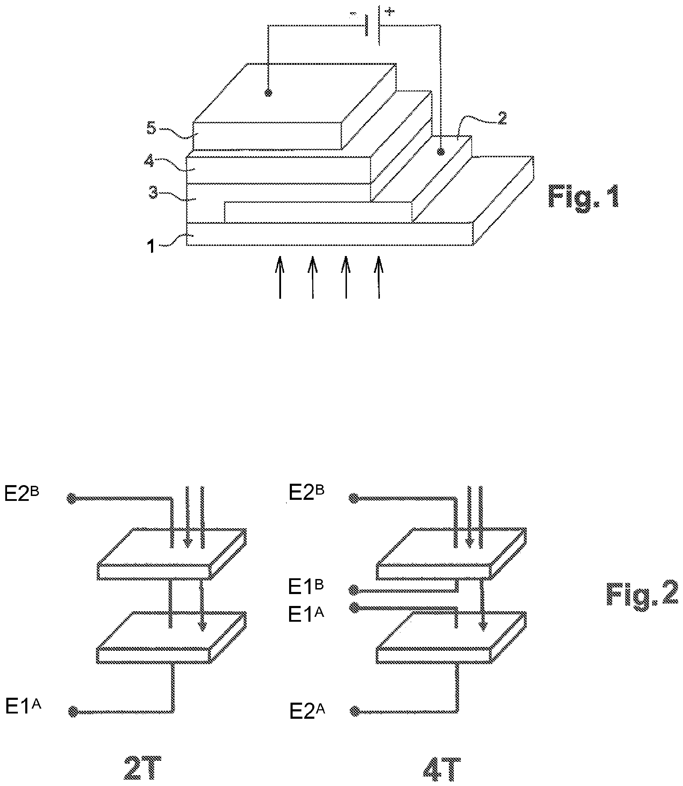

De manière générale, une cellule photovoltaïque organique ou à base de matériau pérovskite, simple jonction, comprend un empilement constitué de (figure 1) :
- un substrat (1) ;
- une première couche conductrice (2) (anode) ;
- une couche HTL (3) (de l'acronyme anglais « hole transporting layer ») également appelée couche P) ;
- une couche active (4) ;
- éventuellement une couche ETL (de l'acronyme anglais « electron transporting layer ») également appelée couche N ;
- une deuxième couche conductrice (5) (cathode).

Une telle cellule simple jonction peut aussi être dénommée empilement de type PIN (matériau type P/matériau intrinsèque/matériau type N), la couche P étant en regard du rayonnement électromagnétique et donc des photons incidents. Au contraire, dans les empilements NIP d'une cellule simple jonction, la couche N est en regard des photons incidents.

Le substrat (1) peut être en plastique ou en verre par exemple.

La première couche conductrice (2) constituant l'anode peut être en oxyde métallique conducteur, par exemple en ITO (oxyde d'indium-étain), AZO (oxyde d'aluminium-zinc), IZO (oxyde d'indium-zinc). Elle peut également se présenter sous forme de structure multicouche de type AZO/Ag/AZO par exemple.

La couche HTL (3), intercalée entre l'anode (2) et la couche active (4), est une couche de transport de trous (HTL, de l'acronyme anglais « hole transport layer »). Il s'agit d'une couche conductrice ou semi-conductrice de type P qui est généralement en polymère conducteur, par exemple le mélange de polymères PEDOT:PSS (PEDOT = poly(3,4-éthylènedioxythiophène) ; PSS = poly(4-styrènesulfonate)).

La couche active (4) est une couche destinée à absorber les photons. Elle permet la création de porteurs de charge libres (trous et électrons). Elle peut être à base de pérovskite.

La couche ETL est une couche de transport d'électrons en matériau de type N.

Comme la première couche conductrice (2), la deuxième couche conductrice (5), c'est-à-dire la cathode, peut être en oxyde métallique conducteur.

Afin d'augmenter l'efficacité des cellules photovoltaïques, des dispositifs photovoltaïques tandem de type NIP/NIP ont récemment été développés. Ces dispositifs tandems permettent d'élargir la gamme d'absorption du spectre électromagnétique, par association de deux cellules absorbant des photons à des longueurs d'onde différentes.

Tel que décrit dans le document NIESEN et al., IEEE, 2016, pages 77-81, les dispositifs tandem peuvent être constitués d'une cellule à base de pérovskite et d'une cellule à base de silicium. Deux types de structure ont été développés : une structure à deux terminaux (2T), et une structure à quatre terminaux (4T) (figure 2). De manière générale, les structures 2T comportent deux électrodes, formant chacune une anode et une cathode communes aux deux sous-cellules ; alors que les structures 4T comportent quatre électrodes, chaque sous-cellule ayant son couple d'électrodes.

Quand bien même les dispositifs en tandem permettent d'augmenter les performances du dispositif photovoltaïque par rapport à une cellule conventionnelle simple jonction, leur stabilité dans le temps est faible. En particulier, la couche pérovskite est sensible à l'eau et aux alcools. En outre, peu de matériaux de la couche P sont compatibles avec la couche pérovskite.

Il existe donc un besoin de développer un dispositif photovoltaïque tandem ayant une bonne stabilité dans le temps et permettant d'associer une cellule à base de pérovskite avec une cellule à base de silicium, dans lequel l'intégrité de la couche pérovskite est préservée durablement.

Le Demandeur a résolu ce problème grâce à un dispositif photovoltaïque dont la cellule à base de pérovskite a une couche HTL spécifique.

### EXPOSE DE L'INVENTION

Le Demandeur a mis au point un dispositif photovoltaïque tandem dont la structure permet d'améliorer la stabilité de la cellule à base de pérovskite et par conséquent du dispositif global. Ce dispositif comprend une couche HTL constituée de deux couches à base d'un mélange de PEDOT:PSS, la couche HTL étant une couche de transport de trous (HTL, de l'acronyme anglais « *hole transport layer* »)*.*

Plus précisément, la présente invention concerne un dispositif photovoltaïque tandem comprenant :
- une sous-cellule A à base de pérovskite, et
- une sous-cellule B à hétérojonction de silicium,
la sous-cellule A contenant successivement :
- une couche HTL de transport de trous étant une bicouche constituée d'une couche neutre HTL-N à base de PEDOT:PSS et d'une couche acide HTL-A à base de PEDOT:PSS,
   le PEDOT étant le poly(3,4-éthylènedioxythiophène),
   le PSS étant le poly(4-styrènesulfonate),
- une couche active à base de pérovskite,
- une couche ETL^{A} de transport d'électrons.
la couche HTL-A étant en contact direct avec la couche active à base de pérovskite.

Dans cet empilement, la couche HTL-A est positionnée entre la couche active à base de pérovskite et la couche HTL-N.

Contrairement aux dispositifs simple jonction pour lesquels l'éclairement se fait généralement à travers le substrat, l'éclairement d'un dispositif tandem est généralement réalisé à partir de la couche N de la sous-cellule à base de pérovskite.

### Sous-cellule A

Comme déjà indiqué, le dispositif photovoltaïque comporte une sous-cellule A à base de pérovskite. Typiquement, la sous-cellule A est dépourvue de couches à base de silicium.

De manière générale, la sous-cellule A comprend successivement :
- une première électrode E1^{A},
- une couche ETL^{A} de transport d'électrons,
- une couche active à base de pérovskite,
- une couche HTL-A,
- une couche HTL-N,
- optionnellement une deuxième électrode E2^{A}.

La première électrode E1^{A} et la deuxième électrode E2^{A} jouent généralement le rôle de de cathode et d'anode.

La première électrode E1^{A} peut être associée à une grille métallique afin de favoriser les contacts électriques extérieurs de la sous-cellule A. Lorsqu'elle est présente, (structure 4T), la deuxième électrode E2^{A} peut également être associée à une grille métallique. Cette grille peut notamment être réalisée en argent.

La première électrode E1^{A} est avantageusement en matériau conducteur ou semiconducteur. Ce matériau peut être avantageusement choisi dans le groupe comprenant les oxydes métalliques conducteurs ou semi-conducteurs. Il peut notamment s'agir de l'ITO (oxyde d'indium-étain), ITOH, l'AZO (oxyde d'aluminium-zinc), l'IZO (oxyde d'indium-zinc), de GZO (oxyde de zinc dopé gallium), d'IOH (oxyde d'indium hydrogéné), IWO, IWOH (oxyde d'indium-tungstène avec ou sans hydrogène), ICO, ICOH (oxyde d'indium-césium avec ou sans hydrogène).

La première électrode E1^{A} peut également se présenter sous forme de structure multicouche, par exemple de type AZO/Ag/AZO ou IZO/Ag/IZO.

Typiquement, la première électrode E1^{A} présente une épaisseur avantageusement comprise entre 100 et 500 nanomètres.

Dans la sous-cellule A, la première électrode E1^{A} est en contact direct avec la couche ETL^{A}.

La couche de transfert d'électrons de la sous-cellule A, notée ETL^{A}, est une couche dite N. Il s'agit généralement d'une couche inorganique transparente et chimiquement inerte vis-à-vis de la pérovskite. La couche ETL^{A} est avantageusement à base d'oxyde de zinc (ZnO) dopé ou non, par exemple l'oxyde d'aluminium-zinc (AZO) ; d'oxyde de titane TiOₓ ; ou de [6,6]-phényl-C₆₁-butyrate de méthyle (PCBM).

Dans la sous-cellule A, la couche ETL^{A} est en contact direct avec la couche à base de pérovskite.

La couche active à base de pérovskite de la sous-cellule A est une couche classique de cellule photovoltaïque à base de pérovskite. Elle comprend avantageusement au moins un matériau pérovskite hybride organique-inorganique. De manière avantageuse, la pérovskite est un matériau comportant 1, 2 ou 3 cations et des anions, par exemple des halogènes, notamment Cl, Br, I, et leurs mélanges.

La pérovskite est avantageusement de type ABX₃ (A et B représentant deux cations différents, et X représentant trois halogènes) dans laquelle :
- A représente avantageusement au moins un ion organo-ammonium, par exemple de type méthylammonium (MA) ou bien formamidinium (FA) ou bien un mélange des deux, éventuellement associé à du césium et/ou du rubidium,
- B représente avantageusement le plomb, l'étain, le bismuth ou l'antimoine,
- X est avantageusement choisi parmi : Cl, Br, I ou une combinaison de ces halogénures.

Par exemple, la pérovskite peut être de type MAPbI₃, ou MAFAPbI₃ ou MAFACsPbI₃. Il peut également s'agir de MAPbI₃₋ₓClₓ avec x compris entre 0 et 10 ou de MAPbI₃₋ₓBrₓ avec x compris entre 0 et 100.

La pérovskite peut être de type bidimensionnel ou tridimensionnel.

La couche active à base de pérovskite présente une épaisseur avantageusement comprise entre 50 nanomètres et 1000 nanomètres, plus avantageusement entre 200 nanomètres et 500 nanomètres.

Dans la sous-cellule A, la couche à base de pérovskite est en contact direct avec la couche HTL-A.

La couche HTL-N et la couche HTL-A forment la couche HTL de la sous-cellule A, les deux couches HTL-N et HTL-A étant composées d'un mélange PEDOT:PSS.

Le mélange de polymères PEDOT:PSS se présente généralement sous forme d'une solution colloïdale. L'ajustement du pH de ce mélange permet ainsi de déposer chacune des couches de PEDOT:PSS dites neutre (HTL-N) et acide (HTL-A).

La couche ainsi formée est alors composée de PEDOT:PSS, avec de préférence des contre-ions de type NH₄⁺, ammonium primaire RNH₃⁺, ammonium secondaire R¹R²NH₂⁺, ammonium tertiaire R¹R²RHN⁺, ammonium quaternaire R¹R²R³R⁴N⁺, Na⁺, ou K⁺. Les groupements R, R¹, R², R³ et R⁴ sont avantageusement des groupements hydrocarbonés en C₁-C₆, préférentiellement des alkyles linéaires.

Par couche HTL-A, on entend que la couche acide en PEDOT:PSS de l'empilement a été formée à partir d'une composition ou d'une solution à base de PEDOT:PSS acide. En d'autres termes, la couche HTL-A est réalisée à partir d'une composition ou solution de PEDOT:PSS ayant un pH inférieur à 5, et plus avantageusement un pH compris entre 1 et 3.

La couche ainsi formée est alors composée de PEDOT:PSS, avec de préférence des contre-ions H+.

Typiquement, la couche HTL-A présente une épaisseur avantageusement comprise entre 10 nanomètres et 100 nanomètres.

Par couche HTL-N, on entend que la couche neutre en PEDOT:PSS de l'empilement a été formée à partir d'une composition ou d'une solution à base de PEDOT:PSS neutralisée. En d'autres termes, la couche HTL-N est réalisée à partir d'une composition ou solution de PEDOT:PSS ayant un pH supérieur ou égal à 5, et plus avantageusement un pH compris entre 5 et 8 et, de préférence, entre 5 et 7.

Typiquement, la couche HTL-N présente une épaisseur avantageusement comprise entre 10 nanomètres et 40 nanomètres.

La couche HTL constituée des couches HTL-N et HTL-A présente une épaisseur avantageusement comprise entre 20 nanomètres et 110 nanomètres, plus avantageusement entre 30 nanomètres et 60 nanomètres.

Dans la sous-cellule A d'un dispositif photovoltaïque de structure 4T, la couche HTL-N est en contact direct avec la deuxième électrode E2^{A}.

La deuxième électrode E2^{A} est avantageusement en matériau conducteur ou semiconducteur. Il peut s'agir des matériaux mentionnés pour la première électrode E1^{A}. En outre, elle peut avoir les caractéristiques mentionnées pour la première électrode E1^{A}.

### Sous-cellule B

Le dispositif photovoltaïque selon l'invention comporte également une sous-cellule B à hétérojonction de silicium. Tout type de cellule à hétérojonction de silicium conventionnelle peut convenir au dispositif photovoltaïque selon l'invention.

De manière générale, la sous-cellule B comprend successivement :
- optionnellement une première électrode E1^{B},
- une couche (SiN) en silicium amorphe ou microcristallin dopé N,
- avantageusement, une couche à base de silicium amorphe intrinsèque servant de couche de passivation,
- un substrat en silicium cristallin dopé N,
- avantageusement, une couche à base de silicium amorphe intrinsèque servant de couche de passivation,
- une couche (SiP) en silicium amorphe ou microcristallin dopé P,
- une deuxième électrode E2^{B}.

La première électrode E1^{B} et la deuxième électrode E2^{B} jouent généralement le rôle de de cathode et d'anode.

La sous-cellule B comprend une première électrode E1^{B} lorsque le dispositif photovoltaïque a une structure 4T.

La première électrode E1^{B} est avantageusement en matériau conducteur ou semiconducteur. Il peut s'agir des matériaux mentionnés pour la première électrode E1^{A} de la sous-cellule A. En outre, elle peut avoir les caractéristiques mentionnées pour la première électrode E1^{A} et être éventuellement associée à une grille métallique.

Dans la sous-cellule A d'un dispositif photovoltaïque de structure 4T, la première électrode E1^{B} est en contact direct avec la couche SiN.

La couche SiN est avantageusement une couche amorphe de silicium type N, plus avantageusement de type a-Si : H dopé N. L'empilement formé par la couche de passivation et la couche de silicium SiP présente une épaisseur avantageusement comprise entre 2 et 30 nanomètres, plus avantageusement entre 5 et 15 nanomètres.

Le substrat en silicium cristallin est avantageusement une couche cristalline de silicium type N, c-Si(N). Elle présente une épaisseur avantageusement comprise entre 50 et 300 nanomètres, plus avantageusement entre 80 et 200 nanomètres.

Il est positionné entre la couche SiP et la couche SiN, le cas échéant entre deux couches de passivation.

La couche SiP est avantageusement une couche amorphe de silicium type P, a-Si(P) : H. Elle présente une épaisseur avantageusement comprise entre 5 et 40 nanomètres, plus avantageusement entre 10 et 20 nanomètres.

La deuxième électrode E2^{B} est avantageusement en matériau conducteur ou semiconducteur. Il peut s'agir des matériaux mentionnés pour la première électrode E1^{A} de la sous-cellule A. En outre, elle peut avoir les caractéristiques mentionnées pour la première électrode E1^{A}.

Conformément à la première électrode E1^{A}, la deuxième électrode E2^{B} peut être associée à une grille métallique. Lorsqu'elle est présente (structure 4T), la première électrode E1^{B} peut également être associée à une grille métallique. Cette grille peut notamment être réalisée en argent ou en cuivre.

Les électrodes, les couches SiP et SiN, les couches de passivation et le substrat en silicium cristallin de la sous-cellule B sont des couches classiques de cellules photovoltaïques à base de silicium.

### Dispositif photovoltaïque tandem

Le dispositif photovoltaïque tandem peut présenter une structure à deux terminaux (2T) ou à quatre terminaux (4T).

Les sous-cellules A et B peuvent y être placées en série lorsqu'elles sont séparées par une couche électroniquement conductrice ou semi-conductrice dite « couche de recombinaison des charges ». Dans ce cas, les tensions des sous-cellules A et B s'additionnent, ce qui nécessite le rééquilibrage des courants des deux sous-cellules de manière à optimiser les performances du dispositif tandem.

Les sous-cellules A et B peuvent également être mises en parallèle lorsqu'elles sont séparées par une couche électroniquement isolante. Dans ce cas, les courants des sous-cellules s'additionnent.

De manière avantageuse, la couche ETL^{A} de la sous-cellule A est en regard du rayonnement électromagnétique et donc des photons incidents. Aussi, en fonction de l'exposition au rayonnement électromagnétique, la sous-cellule A et/ou la sous-cellule B est/sont avantageusement constituée(s) de couches transparentes. La transparence est relative au rayonnement électromagnétique, les sous-cellules A et B absorbant des photons à des longueurs d'onde différentes.

Dans une structure 2T, le dispositif photovoltaïque tandem comprend une seule première électrode et une seule deuxième électrode. Il s'agit alors des électrodes E1^{A} et E2^{B} des sous-cellules A et B respectivement. Dans ce cas, les sous-cellules A et B sont séparées par une couche électroniquement conductrice.

Ainsi, dans une structure 2T, la couche HTL-N de la sous-cellule A et la couche SiN (couche à base de silicium amorphe ou microcristallin dopé N) de la sous-cellule B sont séparées par une couche intermédiaire électroniquement conductrice ou semi-conductrice.

Selon un mode de réalisation particulier, le dispositif tandem présente une structure à 2 terminaux dans laquelle les sous-cellules A et B sont placées en série. Le dispositif tandem comprend alors l'empilement suivant :
- sous-cellule A : E1^{A} / ETL^{A} / couche active à base de pérovskite / HTL-A / HTL-N,
- couche intermédiaire électroniquement conductrice ou semi-conductrice,
- sous-cellule B : couche SiN (couche en silicium amorphe ou microcristallin dopé N) / substrat en silicium cristallin dopé N / couche SiP (couche en silicium amorphe ou microcristallin dopé P) / E2^{B}.

La couche intermédiaire électroniquement conductrice ou semi-conductrice d'une structure 2T est avantageusement transparente au rayonnement électromagnétique. Elle peut notamment être réalisée en un matériau choisi dans le groupe des TCO (oxydes conducteurs transparents) comprenant ITO (oxyde d'indium-étain), AZO (oxyde d'aluminium-zinc), IZO (oxyde d'indium-zinc), IOH (oxyde d'indium hydrogéné), AZO/Ag/IZO, IZO/Ag/IZO, ITOH, IWO, IWOH (oxyde d'indium-tungstène avec ou sans hydrogène), ICO, ICOH (oxyde d'indium-césium avec ou sans hydrogène), et les nanofils d'argent. Il peut également s'agir de GZO (oxyde de zinc dopé gallium).

Dans une structure 4T, le dispositif photovoltaïque tandem comprend deux première électrodes et deux deuxième électrodes, les sous-cellules A et B étant montées en parallèle. Il s'agit alors des électrodes E1^{A} et E2^{A} de la sous-cellule A et des électrodes E1^{B} et E2^{B} de la sous-cellule B. Dans ce cas, les sous-cellules A et B sont séparées par une couche intermédiaire électroniquement isolante.

Selon un mode de réalisation particulier, le dispositif tandem présente une structure à 4 terminaux dans laquelle les sous-cellules A et B sont montées en parallèle. Le dispositif tandem comprend alors l'empilement suivant :
- sous-cellule A : E2^{A} / HTL-N / HTL-A / couche active à base de pérovskite / ETL^{A} / E1^{A}, ou E1^{A} / ETL^{A} / couche active à base de pérovskite / HTL-A / HTL-N / E2^{A},
- couche intermédiaire électroniquement isolante,
- sous-cellule B : E1^{B}/ SiN (couche en silicium amorphe ou microcristallin dopé N) / substrat en silicium cristallin dopé N / SiP (couche en silicium amorphe ou microcristallin dopé P) / E2^{B}.

Ainsi, dans une structure 4T, la couche intermédiaire électroniquement isolante peut séparer la première électrode E1^{A} et la première électrode E1^{B} ou la deuxième électrode E2^{A} et la première électrode E1^{B}.

La couche intermédiaire électroniquement isolante d'une structure 4T est avantageusement réalisée en un matériau thermoplastique. Il peut être choisi dans le groupe comprenant : EVA, polyoléfine, résine ionomère, polyester, polyoléfine greffée (notamment l'Apolhya® de chez Arkema), polyuréthane (TPU), et polymère fluoré. Il peut s'agir de polyéthylène ou de poly(éthylène-acétate de vinyle). Elle peut également être en matériau destiné au collage, par exemple en adhésif sensible à la pression, en résine photosensible comme la colle SU-8, tout type de colle utilisée pour le collage de wafers de silicium. La couche intermédiaire électroniquement isolante peut également résulter de l'activation de surface (SAB, de l'acronyme anglais « Surface Activated Bonding ») par exemple de type Si/Al₂O₃ avec activation de surface, mise en contact avec pression et chauffage pour créer des liaisons covalentes.

La sous-cellule A peut reposer sur un substrat. Ce substrat est avantageusement en un matériau choisi dans le groupe comprenant le verre, PET, et PEN. C'est particulièrement le cas dans une configuration 4T, notamment pour le verre. En revanche, dans le cas d'une configuration 2T, la sous-cellule B fait généralement office de substrat pour la sous-cellule A.

### Procédé de préparation du dispositif photovoltaïque tandem

La présente invention concerne également un procédé de fabrication d'une cellule photovoltaïque tandem à deux terminaux contenant au moins les étapes successives suivantes :
a) réalisation d'une sous-cellule B à base de silicium contenant :
   - une couche (SiN) à base de silicium amorphe ou microcristallin dopé N,
   - un substrat en silicium cristallin dopé N,
   - une couche (SiP) en silicium amorphe ou microcristallin dopé P,
   - une deuxième électrode E2^{B},
   - optionnellement, métallisation de la deuxième électrode E2^{B},
b) formation, sur la couche SiN de la sous-cellule B, d'une couche intermédiaire électroniquement conductrice ou semi-conductrice,
c) réalisation d'une sous-cellule A sur la sous-cellule B selon les étapes suivantes :
   - formation, sur la couche intermédiaire, d'une couche HTL de transport de trous qui est une bicouche constituée d'une couche neutre HTL-N à base de PEDOT:PSS et d'une couche acide HTL-A à base de PEDOT:PSS,
      le PEDOT étant le poly(3,4-éthylènedioxythiophène),
      le PSS étant le poly(4-styrènesulfonate),
      la couche HTL-N étant formée sur la couche intermédiaire,
      la couche HTL-A étant formée sur la couche HTL-N,
   - formation, sur la couche HTL-A, d'une couche active à base de pérovskite,
   - formation, sur la couche active à base de pérovskite, d'une couche N,
   - formation, sur la couche n, d'une première électrode E1^{A},
   - optionnellement, métallisation de la première électrode E1^{A}.

La présente invention concerne également un procédé de fabrication d'une cellule photovoltaïque tandem à quatre terminaux contenant au moins les étapes successives suivantes :
a) réalisation d'une sous-cellule B à base de silicium contenant :
   - une première électrode E1^{B},
   - une couche (SiN) à base de silicium amorphe ou microcristallin dopé N,
   - un substrat en silicium cristallin dopé N,
   - une couche (SiP) en silicium amorphe ou microcristallin dopé P,
   - une deuxième électrode E2^{B},
   - optionnellement, métallisation de la première électrode E1^{B} et/ou de la deuxième électrode E2^{B},
b) optionnellement, formation, sur la première électrode E1^{B} ou sur la deuxième électrode E2^{A}, d'une couche électroniquement isolante,
c) réalisation d'une sous-cellule A selon les étapes suivantes :
   - formation d'une deuxième électrode E2^{A},
   - formation, sur la deuxième électrode E2^{A}, d'une couche HTL de transport de trous qui est une bicouche constituée d'une couche neutre HTL-N à base de PEDOT:PSS et d'une couche acide HTL-A à base de PEDOT:PSS,
      le PEDOT étant le poly(3,4-éthylènedioxythiophène),
      le PSS étant le poly(4-styrènesulfonate),
      la couche HTL-N étant formée sur la deuxième électrode E2^{A},
      la couche HTL-A étant formée sur la couche HTL-N,
   - formation, sur la couche HTL-A, d'une couche active à base de pérovskite,
   - formation, sur la couche active à base de pérovskite, d'une couche N,
   - formation, sur la couche n, d'une première électrode E1^{A},
   - optionnellement, métallisation de la première électrode E1^{A}.
d) association des sous-cellules A et B, avantageusement par lamination, au moyen d'une couche électroniquement isolante
   la couche électroniquement isolante séparant les électrodes E1^{B} et E1^{A} ou les électrodes E1^{B} et E2^{A}.

Pour les structures à deux terminaux, l'étape a) de réalisation d'une sous-cellule B à base de silicium est avantageusement réalisée selon les sous étapes suivantes :
- texturation de la surface et nettoyage d'un substrat en silicium cristallin dopé N,
- avantageusement, dépôt d'une couche à base de silicium amorphe intrinsèque servant de couche de passivation de part et d'autre du substrat en silicium cristallin dopé N,
- dépôt d'une couche SiN en silicium amorphe ou microcristallin dopé N sur une des faces du substrat en silicium cristallin dopé N, avantageusement sur une couche de passivation,
- dépôt d'une couche SiP en silicium amorphe ou microcristallin dopé P sur l'autre face du substrat en silicium cristallin dopé N, avantageusement sur une couche de passivation,
- dépôt d'une couche électroniquement conductrice sur la couche SiP de manière à former une deuxième électrode E2^{B},
- optionnellement, métallisation de la deuxième électrode E2^{B}.

Pour les structures à quatre terminaux, l'étape a) de réalisation d'une sous-cellule B à base de silicium est avantageusement réalisée selon les sous étapes suivantes :
- texturation de la surface et nettoyage d'un substrat en silicium cristallin dopé N,
- avantageusement, dépôt d'une couche à base de silicium amorphe intrinsèque servant de couche de passivation de part et d'autre du substrat en silicium cristallin dopé N,
- dépôt d'une couche SiN en silicium amorphe ou microcristallin dopé N sur une des faces du substrat en silicium cristallin dopé N, , avantageusement sur une couche de passivation,
- dépôt d'une couche SiP en silicium amorphe ou microcristallin dopé P sur l'autre face du substrat en silicium cristallin dopé N,, avantageusement sur une couche de passivation,
- dépôt d'une couche électroniquement conductrice sur la couche SiP de manière à former une deuxième électrode E2^{B},
- dépôt d'une couche électroniquement conductrice sur la couche SiN de manière à former une première électrode E1^{B},
- optionnellement, métallisation de la deuxième électrode E2^{B} et/ou de la première électrode E1^{B}.

L'homme du métier saura adapter l'ordre des différentes étapes de fabrication des cellules à deux ou à quatre terminaux en fonction de l'empilement désiré. Par exemple, il pourra former la couche HTL-A avant de former la couche HTL-N.

De manière avantageuse, l'étape a) de réalisation d'une sous-cellule B à base de silicium comporte en outre une sous étape de traitement ultraviolet-ozone de la couche intermédiaire conductrice ou semi-conductrice.

La couche HTL-N déposée sur la sous-cellule B est avantageusement déposée par voie humide puis recuite à une température comprise entre 80°C et 140°C, préférentiellement sous vide.

La couche HTL-A déposée sur la couche HTL-N est avantageusement déposée par voie humide, puis recuite à une température comprise entre 80°C et 140°C, préférentiellement sous vide. Le recuit permet d'éviter la dissolution de la couche HTL-N lors de la formation de la couche HTL-A. Il en est de même si la couche HTL-A est déposée préalablement à la couche HTL-N.

La formulation de pérovskite déposée sur la couche HTL-A ou HTL-N est avantageusement déposée par voie solvant. La couche pérovskite ainsi obtenue est avantageusement séchée puis recuite à une température inférieure à 150°C.

La couche N est avantageusement déposée par voie solvant.

Les électrodes sont avantageusement déposées par voie vapeur.

La métallisation des électrodes est avantageusement déposée par sérigraphie, jet d'encre ou évaporation. Il s'agit généralement de former une grille.

### Utilisation du dispositif photovoltaïque tandem

Le dispositif photovoltaïque tandem selon l'invention permet d'améliorer le rendement en termes d'énergie générée par photon incident, par rapport aux cellules simples, et ce grâce à la présence de deux types de cellules augmentant la plage d'absorption. En outre, ce dispositif photovoltaïque présente une meilleure stabilité dans le temps grâce à la présence des couches HTL-N et HTL-A.

Ainsi, ce dispositif photovoltaïque tandem peut être utilisé dans tout type d'application nécessitant la génération d'électricité à partir d'énergie solaire.

L'invention et les avantages qui en découlent ressortiront mieux des figures et des exemples suivants donnés de manière non limitative afin d'illustrer l'invention.

### BREVE DESCRIPTION DES FIGURES

La figure 1 illustre une cellule photovoltaïque organique conventionnelle de type PIN simple jonction.
La figure 2 illustre un dispositif photovoltaïque tandem ayant 2 terminaux (2T) ou 4 terminaux (4T).

### EXEMPLES DE REALISATION DE L'INVENTION

### Exemple 1 : Préparation d'un dispositif tandem en structure 2T selon l'invention (INV-1)

De manière générale, le dispositif comprend, en face arrière, une couche de TCO ayant une épaisseur comprise entre 80 nm et 150nm. La métallisation (200 nm à 20 µm) en face arrière est réalisée en argent ou en cuivre, sous la forme d'une plaque ou d'une grille. La couche intermédiaire présente une épaisseur comprise entre 5 nm et 200 nm. En face avant, le dispositif comprend une couche de TCO (100 nm à 1 µm) métallisée (200 nm à 30 µm).

Une sous-cellule B à base de silicium est réalisée selon les étapes suivantes :
- texturation de la surface et nettoyage d'un substrat en silicium cristalline (c-Si(N)) de silicium type N,
- dépôt d'une couche amorphe (a-Si(N)) de silicium type N sur une des faces de la couche c-Si(N),
- dépôt d'une couche amorphe (a-Si(P)) de silicium type P sur l'autre face de la couche c-Si(N),
- dépôt d'une couche électroniquement conductrice (ITO) sur la couche a-Si(P),
- métallisation (argent) de la couche électroniquement conductrice.

Cet empilement constitue une sous-cellule B à base de silicium.

Une couche intermédiaire constituée de ITO (entre 5nm et 200nm d'épaisseur) est ensuite déposée sur la couche amorphe a-Si(N) de la sous-cellule B.

La sous-cellule A est ensuite formée sur cette couche intermédiaire, selon les étapes suivantes :
- dépôt d'une couche HTL-N de transport de trou, de 20 nm d'épaisseur, par voie humide sur la couche intermédiaire,
- recuit de la couche HTL-N, sous vide, à une température de 100°C pendant 60 minutes,
- dépôt d'une couche HTL-A de transport de trou, de 30 nm d'épaisseur, par voie humide sur la couche HTL-N,
- recuit de la couche HTL-A, sous vide, à une température de 100°C pendant 60 minutes, puis à l'air à une température de 140°C pendant 5 minutes,
- dépôt d'une couche à base de pérovskite (MAPbI3), de 350 nm d'épaisseur, par voie solvant sur la couche HTL-A, à partir d'une solution de pérovskite dans le solvant DMSO,
- séchage de la couche pérovskite lors du depot, puis recuit à une température de 80°C pendant 5 minutes,
- dépôt d'une couche N composée de [6,6]-phényl-C₆₁-butyrate de méthyle (PCBM) sur la couche de pérovskite, par enduction centrifuge à 2000 tours/minute pendant 1 minute à partir d'une solution de PCBM à 20mg/ml dans du toluène,
- dépôt d'une couche électroniquement conductrice en oxyde d'indium-étain (ITO), de 100 nm d'épaisseur, sur la couche N par voie vapeur. Pour une cible d'ITO à 97% en poids de In₂O₃ et 3% en poids de SnO₂, le dépôt peut être réalisé à une température initiale de 25°C sans préchauffage à une densité de puissance de 1,8 W/cm² avec un ratio d'oxygène de 1,43%,
- dépôt d'une grille métallique à base d'argent, par sérigraphie à partir d'une pâte constituée de poudre d'argent dispersée dans un liant,
- séchage de la grille métallique pendant 30 secondes à une température de 150°C, puis recuit pendant 10 minutes à 200°C.

La couche HTL-N est réalisée à partir d'une dispersion aqueuse à base du mélange de poly(3,4-ethylenedioxythiophene) et de poly(styrène sulfonate) de sodium neutre commercialisée sous le nom de Clevios™ P jet N par Héraeus et dont le pH est compris entre 5 et 8.

La couche HTL-A réalisée à partir d'une dispersion aqueuse à base du mélange de poly(3,4-ethylenedioxythiophene) et de poly(styrène sulfonate) de sodium acide commercialisé sous le nom de Clevios™ PH par Héraeus et dont le PH est compris entre 1,5 et 2,5.

La cellule photovoltaïque résultant de ces étapes est une cellule tandem comprenant une sous-cellule B à base de silicium et une sous-cellule A à base de pérovskite.

## Revendications

1. Dispositif photovoltaïque tandem comprenant :
- une sous-cellule A à base de pérovskite, et
- une sous-cellule B à hétéroj onction de silicium,
**caractérisé en ce que** la sous-cellule A comprend successivement :
• une couche HTL de transport de trous étant une bicouche constituée d'une couche neutre HTL-N à base de PEDOT:PSS et d'une couche acide HTL-A à base de PEDOT:PSS,
le PEDOT étant le poly(3,4-éthylènedioxythiophène),
le PSS étant le poly(4-styrènesulfonate),
• une couche active à base de pérovskite,
• une couche ETL^{A} de transport d'électrons.
la couche HTL-A étant en contact direct avec la couche active à base de pérovskite.

2. Dispositif photovoltaïque tandem selon la revendication 1, ***caractérisé* en ce que** la sous-cellule A comprend successivement :
- une première électrode E1^{A},
- une couche ETL^{A} de transport d'électrons,
- une couche active à base de pérovskite,
- une couche HTL-A,
- une couche HTL-N,
- optionnellement une deuxième électrode E2^{A}.

3. Dispositif photovoltaïque tandem selon la revendication 1 ou 2, ***caractérisé* en ce que** la couche HTL-A de la sous-cellule A est réalisée à partir d'une composition de PEDOT/PSS ayant un pH inférieur à 5, avantageusement compris entre 1 et 3.

4. Dispositif photovoltaïque tandem selon l'une des revendications 1 à 3, ***caractérisé* en ce que** la couche HTL-N de la sous-cellule A est réalisée à partir d'une composition de PEDOT/PSS ayant un pH supérieur ou égal à 5, avantageusement compris entre 5 et 8, et plus avantageusement entre 5 et 7.

5. Dispositif photovoltaïque tandem selon l'une des revendications 1 à 4, ***caractérisé* en ce que** la sous-cellule B comprend successivement :
- optionnellement une première électrode E1^{B},
- une couche (SiN) à base de silicium amorphe ou microcristallin dopé N,
- avantageusement, une couche à base de silicium amorphe intrinsèque servant de couche de passivation,
- un substrat en silicium cristallin dopé N,
- avantageusement, une couche à base de silicium amorphe intrinsèque servant de couche de passivation,
- une couche (SiP) en silicium amorphe ou microcristallin dopé P,
- une deuxième électrode E2^{B}.

6. Dispositif photovoltaïque tandem selon la revendication 5, ***caractérisé* en ce que** le dispositif photovoltaïque présente une structure à 2 terminaux dans laquelle les sous-cellules A et B sont placées en série,
le dispositif photovoltaïque tandem comprenant l'empilement suivant :
- sous-cellule A : E1^{A} / ETL^{A} / couche active à base de pérovskite / HTL-A / HTL-N,
- couche intermédiaire électroniquement conductrice ou semi-conductrice,
- sous-cellule B : couche SiN / substrat en silicium cristallin dopé N / couche SiP /E2^{B}

7. Dispositif photovoltaïque tandem selon la revendication 5, ***caractérisé* en ce que** le dispositif photovoltaïque présente une structure à quatre terminaux dans laquelle les sous-cellules A et B sont montées en parallèle,
le dispositif photovoltaïque tandem comprenant l'empilement suivant :
- sous-cellule A : E2^{A} / HTL-N / HTL-A / couche active à base de pérovskite / ETL^{A} / E1^{A},
- couche intermédiaire électroniquement isolante,
- sous-cellule B : E1^{B} / couche SiN / substrat en silicium cristallin dopé N / couche SiP / E2^{B}

8. Dispositif photovoltaïque tandem selon la revendication 5, ***caractérisé* en ce que** le dispositif photovoltaïque présente une structure à quatre terminaux dans laquelle les sous-cellules A et B sont montées en parallèle,
le dispositif photovoltaïque tandem comprenant l'empilement suivant :
- sous-cellule A: E1^{A} / ETL^{A} / couche active à base de pérovskite / HTL-A / HTL-N / E2^{A},
- couche intermédiaire électroniquement isolante,
- sous-cellule B : E1^{B} / couche SiN / substrat en silicium cristallin dopé N / couche SiP / E2^{B}

9. Procédé de fabrication d'une cellule photovoltaïque tandem à deux terminaux, selon l'une des revendications 1 à 5, contenant au moins les étapes successives suivantes :
a) réalisation d'une sous-cellule B à base de silicium contenant :
- une couche (SiN) à base de silicium amorphe ou microcristallin dopé N,
- un substrat en silicium cristallin dopé N,
- une couche (SiP) en silicium amorphe ou microcristallin dopé P,
- une deuxième électrode E2^{B},
- optionnellement, métallisation de la deuxième électrode E2^{B},
b) formation, sur la couche SiN de la sous-cellule B, d'une couche intermédiaire électroniquement conductrice ou semi-conductrice,
c) réalisation d'une sous-cellule A sur la sous-cellule B selon les étapes suivantes :
- formation, sur la couche intermédiaire, d'une couche HTL de transport de trous qui est une bicouche constituée d'une couche neutre HTL-N à base de PEDOT:PSS et d'une couche acide HTL-A à base de PEDOT:PSS,
le PEDOT étant le poly(3,4-éthylènedioxythiophène),
le PSS étant le poly(4-styrènesulfonate),
la couche HTL-N étant formée sur la couche intermédiaire,
la couche HTL-A étant formée sur la couche HTL-N,
- formation, sur la couche HTL-A, d'une couche active à base de pérovskite,
- formation, sur la couche active à base de pérovskite, d'une couche N,
- formation, sur la couche n, d'une première électrode E1^{A},
- optionnellement, métallisation de la première électrode E1^{A}.

10. Procédé de fabrication d'une cellule photovoltaïque tandem à quatre terminaux selon la revendication 7 ou 8, contenant au moins les étapes successives suivantes :
a) réalisation d'une sous-cellule B à base de silicium contenant :
- une première électrode E1^{B},
- une couche (SiN) à base de silicium amorphe ou microcristallin dopé N,
- un substrat en silicium cristallin dopé N,
- une couche (SiP) en silicium amorphe ou microcristallin dopé P,
- une deuxième électrode E2^{B},
- optionnellement, métallisation de la première électrode E1^{B} et/ou de la deuxième électrode E2^{B},
b) optionnellement, formation, sur la première électrode E1^{B} ou sur la deuxième électrode E2^{A}, d'une couche électroniquement isolante,
c) réalisation d'une sous-cellule A selon les étapes suivantes :
- formation d'une deuxième électrode E2^{A},
- formation, sur la deuxième électrode E2^{A}, d'une couche HTL de transport de trous qui est une bicouche constituée d'une couche neutre HTL-N à base de PEDOT:PSS et d'une couche acide HTL-A à base de PEDOT:PSS,
le PEDOT étant le poly(3,4-éthylènedioxythiophène),
le PSS étant le poly(4-styrènesulfonate),
la couche HTL-N étant formée sur la deuxième électrode E2^{A},
la couche HTL-A étant formée sur la couche HTL-N,
- formation, sur la couche HTL-A, d'une couche active à base de pérovskite,
- formation, sur la couche active à base de pérovskite, d'une couche N,
- formation, sur la couche n, d'une première électrode E1^{A},
- optionnellement, métallisation de la première électrode E1^{A}.
d) association des sous-cellules A et B au moyen d'une couche électroniquement isolante
la couche électroniquement isolante séparant les électrodes E1^{B} et E1^{A} ou les électrodes E1^{B} et E2^{A}.

## Patentansprüche

1. Tandem-Fotovoltaikzelle mit:
- einer Subzelle A auf Perowskit-Basis, und
- einer Subzelle B mit Silizium-Heteroübergang,
***dadurch gekennzeichnet, dass*** die Subzelle A aufeinanderfolgend enthält:
• eine HTL-Loch-Transportschicht, bei der es sich um eine neutrale HTL-N-Doppelschicht auf Basis von PEDOT:PSS handelt und eine HTL-A-Säureschicht auf Basis von PEDOT:PSS,
wobei es sich bei PEDOT um Poly(3,4-ethylendioxythiophen) handelt,
wobei es sich bei PSS um Poly(4-styrolsulfonat) handelt,
• eine aktive Schicht auf Basis von Perowskit,
• eine Schicht ETL^{A} für den Elektronentransport,
wobei die HTL-A-Schicht in direktem Kontakt mit der aktiven Schicht auf Perowskit-Basis steht.

2. Tandem-Fotovoltaikzelle nach Anspruch 1, ***dadurch gekennzeichnet, dass*** die Subzelle A aufeinanderfolgend enthält:
- eine erste Elektrode E1^{A}
- eine Schicht ETL^{A} für den Elektronentransport,
- eine aktive Schicht auf Basis von Perowskit,
- eine HTL-A-Schicht,
- eine HTL-N-Schicht,
- optional eine zweite Elektrode E2^{A}.

3. Tandem-Fotovoltaikzelle nach Anspruch 1 oder 2, ***dadurch gekennzeichnet, dass*** die HTL-A-Schicht der Subzelle A aus einer PEDOT/PSS-Zusammensetzung hergestellt wird, die einen pH-Wert von unter 5 hat, vorteilhafterweise zwischen 1 und 3.

4. Tandem-Fotovoltaikzelle nach einem der Ansprüche 1 bis 3, ***dadurch gekennzeichnet, dass*** die HTL-N-Schicht der Subzelle A aus einer PEDOT/PSS-Zusammensetzung hergestellt wird, die einen pH-Wert von gleich oder größer 5 hat, vorteilhafterweise zwischen 5 und 8, und noch besser zwischen 5 und 7.

5. Tandem-Fotovoltaikzelle nach einem der Ansprüche 1 bis 4, ***dadurch* ge*kennzeichnet, dass*** die Subzelle B aufeinanderfolgend enthält:
- optional eine erste Elektrode E1^{B},
- eine Schicht (SiN) auf Basis von amorphem oder mikrokristallinem N-dotiertem Silizium,
- vorteilhafterweise eine Schicht aus intrinsischem amorphem Silizium, die als Passivierungsschicht dient,
- ein Substrat aus N-dotiertem kristallinem Silizium,
- vorteilhafterweise eine Schicht auf Basis von amorphem, intrinsischem Silizium, die als Passivierungsschicht dient,
- eine Schicht (SiP) aus amorphem oder mikrokristallinem P-dotiertem Silizium,
- eine zweite Elektrode E2^{B}

6. Tandem-Fotovoltaikzelle nach Anspruch 5, ***dadurch gekennzeichnet, dass*** die Fotovoltaikzelle eine Struktur mit 2 Terminals aufweist, in der die Subzellen A und B in Reihe angeordnet sind,
wobei die Tandem-Fotovoltaikzelle den folgenden Stapel umfasst:
- Subzelle A: E1^{A} / ETL^{A} / aktive Schicht auf Perowskit-Basis/ HTL-A / HTL-N,
- elektronisch leitende oder halbleitende Schicht;
- Subzelle B: SiN-Schicht / Substrat aus N-dotiertem kristallinen Silizium, SiP-Schicht.

7. Tandem-Fotovoltaikzelle nach Anspruch 5, ***dadurch gekennzeichnet, dass*** die Fotovoltaikzelle eine Struktur mit vier Terminals aufweist, in der die Subzellen A und B parallel montiert sind,
wobei die Tandem-Fotovoltaikzelle dabei den folgenden Stapel enthält:
- Subzelle A: E2^{A} / HTL-N / HTL-A / aktive Schicht auf Perowskit-Basis / ETL^{A} / E1^{A},
- elektronisch isolierende Zwischenschicht,
- Subzelle B: E1^{B} / SiN-Schicht / N-dotiertes kristallines Siliziumsubstrat / SiP / E2^{B}-Schicht.

8. Tandem-Fotovoltaikzelle nach Anspruch 5, ***dadurch gekennzeichnet, dass*** die Tandem-Fotovoltaikzelle eine Struktur mit vier Terminals aufweist, in der die Subzellen A et B parallel montiert sind,
wobei die Tandem-Fotovoltaikzelle den folgenden Stapel enthält:
- Subzelle A: E1^{A} / ETL^{A} / aktive Schicht auf Perowskit-Basis / HTL-A / HTL-N / E2^{A},
- elektronisch isolierende Zwischenschicht,
- Subzelle B: E1^{B} / SiN-Schicht / N-dotiertes kristallines Siliziumsubstrat /- SiP / E2^{B}-Schicht.

9. Verfahren zur Herstellung einer Tandem-Fotovoltaikzelle mit zwei Terminals nach einem der Ansprüche 1 bis 5, das mindestens die folgenden aufeinanderfolgenden Schritte umfasst:
a) Herstellung einer Subzelle B auf Silizium-Basis, mit:
- einer Schicht (SiN) auf Basis von amorphem oder mikrokristallinem N-dotiertem Silizium,
- ein Substrat aus N-dotiertem kristallinen Silizium,
- eine (SiP)- Schicht aus amorphem oder mikrokristallinem P -dotiertem Silizium,
- eine zweite Elektrode E2^{B},
- optional Metallbeschichtung der zweiten Elektrode E2B,
b) Bildung auf der SiN-Schicht der Subzelle B, einer elektronisch leitenden oder halbleitenden Zwischenschicht,
c) Ausführung einer Subzelle A auf der Subzelle B entsprechend den folgenden Schritten:
- Bildung auf der Zwischenschicht einer HTL-Loch-Transportschicht, bei der es sich um eine Doppelschicht handelt, die aus einer neutralen HTL-N-Schicht auf Basis von PEDOT:PSS und einer HTL-A-Säureschicht auf Basis von PEDOT:PSS besteht,
wobei es sich bei PEDOT um Poly(3,4-ethylendioxythiophen) handelt,
wobei es sich bei PSS um Poly(4-styrolsulfonat) handelt,
wobei die HTL-N-Schicht auf der Zwischenschicht gebildet wird,
wobei die HTL-A-Schicht auf der HTL-N-Schicht gebildet wird,
- Bildung auf der HTL-A-Schicht einer aktiven Schicht auf Perowskit-Basis,
- Bildung einer N-Schicht auf der aktiven Schicht auf Perowskit-Basis,
- Bildung auf der n-Schicht, einer ersten Elektrode E1^{A},
- optional Metallbeschichtung der ersten Elektrode E1^{A}.

10. Verfahren zur Herstellung einer Tandem-Fotovoltaikzelle mit vier Terminals nach Anspruch 7 oder 8, die mindestens die folgenden aufeinanderfolgenden Schritte enthält:
a) Herstellung einer Subzelle B auf Silizium-Basis, mit
- einer ersten Elektrode E1^{B},
- einer Schicht (SiN) auf Basis von amorphem oder mikrokristallinem N-dotiertem Silizium,
- einem Substrat aus N-dotiertem kristallinen Silizium,
- einer Schicht (SiP) aus amorphem oder mikrokristallinem P-dotiertem Silizium,
- einer zweiten Elektrode E2^{B}
- optional Metallbeschichtung der ersten Elektrode EI^{B} und/oder der zweiten Elektrode E2^{B}
b) optional Bildung auf der ersten Elektrode EI^{B} oder auf der zweiten Elektrode E2^{A}, einer elektronisch isolierenden Schicht,
c) Herstellung einer Subzelle A nach den folgenden Schritten:
- Bildung einer zweiten Elektrode E2,
- Bildung auf der zweiten Elektrode E2^{A}, einer HTL-Loch-Transportschicht, bei der es sich um eine Doppelschicht handelt, die aus einer neutralen HTL-N-Schicht auf Basis von PEDOT:PSS und einer Säureschicht HTL-A auf Basis von PEDOT:PSS besteht, wobei es sich bei PEDOT um Poly(3,4-ethylendioxythiophen) handelt,
wobei es sich bei PSS um Poly(4-styrolsulfonat) handelt,
wobei die HTL-N-Schicht auf der zweiten Elektrode E2^{A} gebildet wird,
wobei die HTL-A-Schicht auf der HTL-N-Schicht gebildet wird,
- Bildung auf der HTL-A-Schicht einer aktiven Schicht auf Perowskit-Basis,
- Bildung auf der aktiven Schicht auf Perowskit-Basis einer Schicht N,
- Bildung auf der n-Schicht, einer ersten Elektrode E1,
- optional Metallbeschichtung der ersten Elektrode EI^{A}.
d) Verbindung der Subzellen A und B mittels einer elektronisch isolierenden Schicht,
wobei die elektronisch isolierende Schicht die Elektroden E1^{B} und E1^{A} oder die Elektroden EI^{B} und E2^{A} trennt..

## Claims

1. A tandem photovoltaic device comprising:
- a sub-cell A based on perovskite, and
- a silicon heterojunction sub-cell B,
**characterized in that** the sub-cell A comprises, in succession:
• a hole transport layer HTL, which is a bilayer constituted by a neutral layer HTL-N based on PEDOT:PSS and an acid layer HTL-A based on PEDOT:PSS,
PEDOT being poly(3,4-ethylenedioxythiophene),
PSS being poly(4-styrenesulphonate),
• an active layer based on perovskite,
• an electron transport layer ETL^{A},
wherein the layer HTL-A is in direct contact with the active layer based on perovskite.

2. The tandem photovoltaic device as claimed in claim 1, ***characterized* in that** the sub-cell A comprises, in succession:
- a first electrode E1^{A},
- an electron transport layer ETL^{A},
- an active layer based on perovskite,
- a layer HTL-A,
- a layer HTL-N,
- optionally, a second electrode E2^{A}.

3. The tandem photovoltaic device as claimed in claim 1 or claim 2, ***characterized* in that** the layer HTL-A of the sub-cell A is produced from a PEDOT:PSS composition having a pH of less than 5, advantageously in the range 1 to 3.

4. The tandem photovoltaic device according to one of claims 1 to 3, ***characterized* in that** the layer HTL-N of the sub-cell A is produced from a PEDOT:PSS composition having a pH which is greater than or equal to 5, advantageously in the range 5 to 8, and more advantageously in the range 5 to 7.

5. The tandem photovoltaic device according to one of claims 1 to 4, ***characterized* in that** the sub-cell B comprises, in succession:
- optionally, a first electrode E1^{B},
- a layer (SiN) based on N-doped amorphous or microcrystalline silicon,
- advantageously, a layer based on intrinsic amorphous silicon acting as a passivation layer,
- an N-doped crystalline silicon substrate,
- advantageously, a layer based on intrinsic amorphous silicon acting as a passivation layer,
- a P-doped amorphous or microcrystalline silicon layer (SiP),
- a second electrode E2^{B}.

6. The tandem photovoltaic device as claimed in claim 5, ***characterized* in that** the photovoltaic device has a two-terminal structure in which the sub-cells A and B are placed in series,
the tandem photovoltaic device comprising the following stack:
- sub-cell A: E1^{A} / ETL^{A} / active layer based on perovskite / HTL-A / HTL-N,
- electronically conductive or semiconductive intermediate layer,
- sub-cell B: SiN layer / N-doped crystalline silicon substrate / SiP layer / E2^{B}.

7. The tandem photovoltaic device as claimed in claim 5, ***characterized* in that** the photovoltaic device has a four-terminal structure in which the sub-cells A and B are connected in parallel,
the tandem photovoltaic device comprising the following stack:
- sub-cell A: E2^{A} / HTL-N / HTL-A / active layer based on perovskite / ETL^{A} / E1^{A},
- electronically insulating intermediate layer,
- sub-cell B: E1^{B} / SiN layer / N-doped crystalline silicon substrate / SiP layer / E2^{B}.

8. The tandem photovoltaic device as claimed in claim 5, ***characterized* in that** the photovoltaic device has a four-terminal structure in which the sub-cells A and B are connected in parallel,
the tandem photovoltaic device comprising the following stack:
- sub-cell A: E1^{A} / ETL^{A} / active layer based on perovskite / HTL-A / HTL-N / E2^{A},
- electronically insulating intermediate layer,
- sub-cell B: E1^{B} / SiN layer / N-doped crystalline silicon substrate / SiP layer / E2^{B}.

9. A process for the production of a two-terminal tandem photovoltaic device as claimed in one of claims 1 to 5, containing at least the following steps in succession:
a) production of a silicon-based sub-cell B containing:
- a layer (SiN) based on N-doped amorphous or microcrystalline silicon,
- an N-doped crystalline silicon substrate,
- a P-doped amorphous or microcrystalline silicon layer (SiP),
- a second electrode E2^{B},
- optionally, metallization of the second electrode E2^{B},
b) formation of an electronically conductive or semiconductive intermediate layer on the SiN layer of sub-cell B,
c) production of a sub-cell A on the sub-cell B in accordance with the following steps:
- on the intermediate layer, formation of a hole-transporting layer HTL which is a bilayer constituted by a neutral layer HTL-N based on PEDOT:PSS and an acid layer HTL-A based on PEDOT:PSS,
PEDOT being poly(3,4-ethylenedioxythiophene),
PSS being poly(4-styrenesulphonate),
the layer HTL-N being formed on the intermediate layer,
the layer HTL-A being formed on the layer HTL-N,
- formation, on the layer HTL-A, of an active layer based on perovskite,
- formation of a layer N on the active layer based on perovskite,
- formation, on the layer N, of a first electrode E1^{A},
- optionally, metallization of the first electrode E1^{A}.

10. A process for the production of a four-terminal tandem photovoltaic cell as claimed in claim 7 or 8, containing at least the following steps in succession:
a) production of a silicon-based sub-cell B containing:
- a first electrode E1^{B},
- a layer (SiN) based on N-doped amorphous or microcrystalline silicon,
- an N-doped crystalline silicon substrate,
- a P-doped amorphous or microcrystalline silicon layer (SiP),
- a second electrode E2^{B},
- optionally, metallization of the first electrode E1^{B} and/or the second electrode E2^{B},
b) optionally, forming an electronically insulating layer on the first electrode E1^{B} or on the second electrode E2^{A},
c) production of a sub-cell A in accordance with the following steps:
- formation of a second electrode E2^{A},
- formation, on the second electrode E2^{A}, of a hole transport layer HTL which is a bilayer constituted by a neutral layer HTL-N based on PEDOT:PSS and an acid layer HTL-A based on PEDOT:PSS,
PEDOT being poly(3,4-ethylenedioxythiophene),
PSS being poly(4-styrenesulphonate),
the layer HTL-N being formed on the second electrode E2^{A}, the layer HTL-A being formed on the layer HTL-N,
- formation, on the layer HTL-A, of an active layer based on perovskite,
- formation of a layer N on the active layer based on perovskite,
- formation, on the layer N, of a first electrode E1^{A},
- optionally, metallization of the first electrode E1^{A},
d) association of the sub-cells A and B by means of an electronically insulating layer,
the electronically insulating layer separating the electrodes E1^{B} and E1^{A} or the electrodes E1^{B} and E2^{A}.
